Europäisches Patentamt

European Patent Office

Office européen des brevets

(11) Publication number: **0 068 986**
A1

(12) # EUROPEAN PATENT APPLICATION

(21) Application number: 82401107.6

(51) Int. Cl.³: **G 01 R 1/067**, G 01 R 1/073

(22) Date of filing: 18.06.82

(30) Priority: 23.06.81 US 276583

(43) Date of publication of application: 05.01.83 Bulletin 83/1

(84) Designated Contracting States: CH DE FR GB IT LI NL

(71) Applicant: FAIRCHILD CAMERA & INSTRUMENT CORPORATION, 464 Ellis Street, Mountain View California 94042 (US)

(72) Inventor: Knowlton, Herbert A., Lot 25 Malta Mobile Acres R.D. 3, Ballston Spa New York 12020 (US)

(74) Representative: Chareyron, Lucien et al, Schlumberger Limited 42, rue Saint-Dominique, F-75340 Paris Cedex 07 (FR)

(54) Two-part contact probe assembly.

(57) A two-part contact probe assembly (100) of the type utilized for making electrical contact to points (110) of a printed circuit board (112) for testing the electrical characteristics of the board. The assembly comprises a hollow pin (102) which is telescopically mounted on a receptacle post (104). The receptacle post is fixedly mounted in a non-conductive base (106). A spring (108) is mounted within a pin (102) and acted on by the post such that the pin is biased toward a contact point (110) on a printed circuit board (112) when the pin is brought into contact with the contact point.

## TWO-PART CONTACT PROBE ASSEMBLY

TECHNICAL FIELD

This invention relates to means for making electrical contact to points of a printed circuit board and particularly to a two-part contact probe assembly of the type utilized in testing the electrical characteristics of printed circuit boards.

BACKGROUND ART

In the automatic test equipment industry, it is well known to test components mounted on a printed circuit board by electrically engaging the board at a plurality of its nodes with a corresponding plurality of contact probes which are biased toward the board by a corresponding plurality of springs.

Prior methods for engaging the nodes of the board utilize a three-part probe assembly which comprises a spring-loaded pin which is confined within a tubular pin housing, the pin housing being plugged into a tubular receptacle which is mounted in a non-conductive base. The current path from the printed circuit board through the three-part assembly is as follows: The head or point of the pin contacts a point or node on the printed circuit board which is to be tested. Current then passes through the pin to the pin housing and from the pin housing to the receptacle. A wire connected to the receptacle then passes current to the diagnostic center of the automatic test equipment.

0068986

## SUMMARY OF THE INVENTION

A general object of the present invention is to provide a two-part contact probe assembly which eliminates the pin housing common to the prior art.

This and other objects of the invention are attained in accordance with one aspect of the invention by a contact probe assembly of the type utilized for making electrical contact to points of a printed circuit board for testing the electrical characteristics of the board, comprising: a hollow pin telescopically mounted on a receptacle post, said post being fixedly mounted in a non-conductive base; and a spring mounted within said pin and acted on by said post such that said pin is biased toward a contact point on said printed circuit board when said pin is brought into contact with said contact point.

## BEST MODE FOR CARRYING OUT THE INVENTION

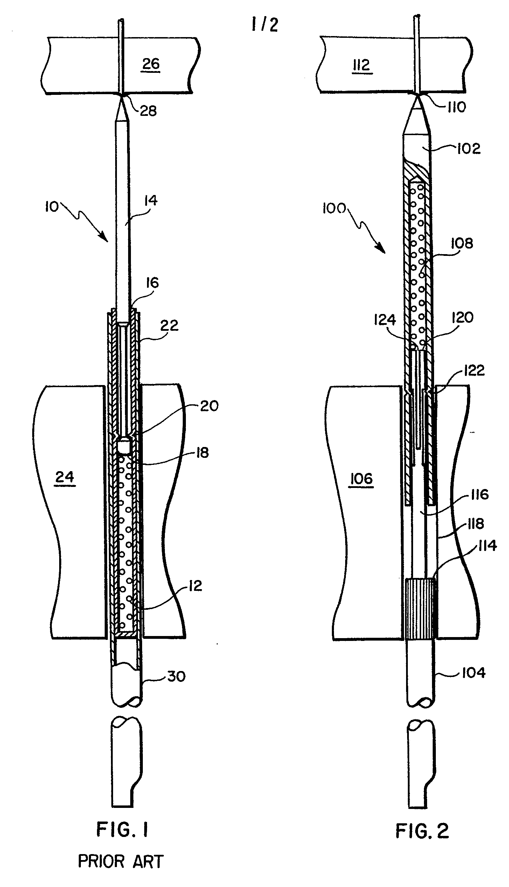

Fig. 1 shows a three-part contact probe assembly 10 which is typical of the prior art. A spring 12 loads a pin 14 which is slidably mounted within a tubular pin housing 16. The pin 14 is retained within the pin housing 16 when the pin 14 is fully extended by a retaining shoulder 18 which is formed at the lower end of the pin 14 and engages a crimp 20 formed in the pin housing 16. The pin housing 16 and the pin 14 mounted therein are plugged into a tubular receptacle 22 which is fixedly mounted in a nonconductive base 24.

The current path from the printed circuit board 26 under test through the contact probe assemly shown in Fig. 1 is as follows: The head or point of the pin 14 contacts a point or node 28 on the printed circuit board 26 which is to be tested. Current passes through pin 14 to the pin housing 16 and from the pin housing 16 to the

0068986

receptacle 22. A wire or contact 30 connected to the receptacle 22 passes current to the diagnostic center of the test equipment.

The two-part contact probe assembly 100 of the present invention, shown in Fig. 2, comprises a hollow pin 102 which is telescopically mounted on receptacle post 104 which is fixedly mounted in a nonconductive base 106. A spring 108 is mounted within the hollow pin 102. When the pin 102 is brought into contact with a contact point or node 110 on a printed circuit board 112 under test, the receptacle post 104 acts on the spring 108 to load the pin 102 and bias it toward the contact point or node 110. In the embodiment illustrated in Fig. 2, the spring 108 is in direct contact with the receptacle post 104. However, an intervening member such as a plug or ball can be positioned between the spring and the receptacle post without deviating from the concept of the invention.

In the preferred embodiment illustrated in Fig. 2, the receptacle post 104 is fixedly retained in a hole 118 formed in the base 106 by means of a knurl 114 which is formed as part of the receptacle post 104 and is pressed into the base 106. A rod-like member 116 extends from the knurl 114. The pin 102, which has an inside diameter slightly greater than the diameter of the rod-like member 116, is telescopically mounted over the member 116. By properly dimensioning the inside and outside diameters of the pin 102, the diameter of the member 116 and the diameter of the hole 118, it is possible to telescopically mount the pin 102 with respect to the receptacle post 104 while maintaining electrical contact therebetween.

As shown in Fig. 2, a pin retaining shoulder 120 is formed at the end of the member 116. When the pin 102 is fully extended, the retaining shoulder 120 engages a crimp 122 formed in the pin 102 to prevent the pin 102 from coming free of the receptacle post 104. A saw cut 124 formed in the end of the member 116 provides critical loading to assist in holding pin 102 and in maintaining the pin 102 and receptacle post 104 in parallel telescoping relationship.

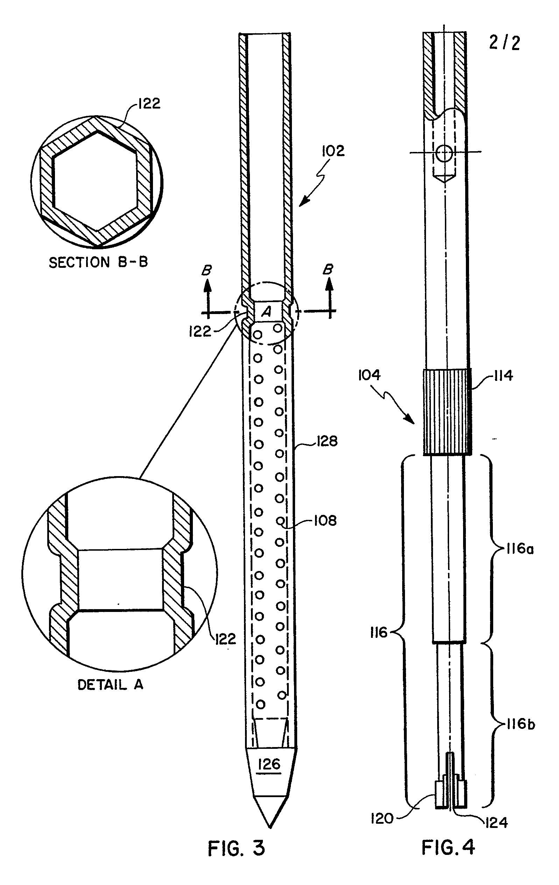

As shown in Fig. 3, in the preferred embodiment, the pin 102 comprises a contact point 126 which is mounted in the end of a hollow probe tube 128. The contact point has a Rockwell hardness of about 55 - 60 Rockwell "C", preferably about 56 - 58 Rockwell "C". In the preferred embodiment, the contact point is SANDVIK 4C27A which is hardened in an inert atmosphere. The contact point is nickle plated to a maximum thickness of about 0.00010 and then gold plated to a maximum thickness of about 0.00005. The probe tube 128 is made of berilium copper which is hardened to about 37 - 42 Rockwell "C". The probe tube 128 is nickle plated to a maximum thickness of about 0.00010 and then gold plated to a maximum thickness of about 0.00005. It is preferred that the crimp 122 be hexagonal in cross section as shown in Section "B-B" to Fig. 3. The spring 108 disposed within the probe 128 is formed of music wire. The preferred spring constant is 1.88 lbs. force per 1" of travel.

As shown in Fig. 4, in the preferred embodiment, the rod-like member 116 comprises a first section 116a which extends from the knurl 114 and a second portion 116b which extends from the first portion 116a. A retaining shoulder 120 is formed at the end of the second portion 116b. The saw cut 124 formed in the member 116 is about 0.006 wide and about 0.060 deep. The depth of the saw cut 124 is critical for retaining the pin 102. The receptacle post 104 is made from berilium copper which is hardened to about 37 - 42 Rockwell "C". The post 104 is nickle plated to a maximum thickness of about 0.00010 and then gold plated to a maximum thickness of about 0.00005.

All dimensions stated above are after plating and are in inches.

By eliminating the pin housing, the probe assembly of the present invention eliminates one contact point and thus reduces the current path through the assembly. The assembly also allows the pin diameter to be increased by approximately 25% thereby increasing current carrying capacity and strength. Since the size of the pin is increased, the size of the spring may also be increased by approximately 25%, increasing the life of the assembly. At the same time, the assembly retains the pluggable characteristics of the prior art three-part assemblies.

The probe assembly of the present invention provides means for making electrical contact to points or nodes of a printed circuit board where the contact points are positioned on a high density grid pattern of 0.050" or less.

1. A contact probe assembly of the type utilized for making electrical contact to points of a printed circuit board for testing the electrical characteristics of the board, characterized by:

a) a hollow pin telescopically mounted on a receptacle post, said post being fixedly mounted in a non-conductive base; and

b) a spring mounted within said pin and acted on by said post such that said pin is biased toward a contact point on said printed circuit board when said pin is brought into contact with said contact point.

2. A contact probe assembly according to claim 1 characterized in that said spring is in direct contact with said receptacle post.

3. A contact probe assembly as in claim 1 or 2 characterized in that said pin comprises a contact point mounted in the end of a hollow probe tube.

4. A contact probe assembly as in claim 3 characterized in that said contact point has a hardness of about 55-60 Rockwell "C".

5. A contact probe assembly as in claim 3 characterized in that said contact point has a hardness of about 56-58 Rockwell "C".

6. A contact probe assembly as in claim 4 or claim 5 characterized in that said probe tube has a hardness of about 37-42 Rockwell "C".

0068986

7.  A contact probe assembly as in any previous claim characterized in that said pin is retained on said receptacle post by means of a pin retaining shoulder formed at the end of said post which engages a crimp formed in said pin when said pin is fully extended.

8.  A contact probe assembly as in claim 7 characterized in that said crimp is hexagonal in cross-section.

9.  A contact probe assembly as in any one of claims 1-6 characterized in that said pin is retained on said receptacle post by means of a saw cut formed in the end of said post.

10.  A contact probe assembly as in any one of claims 1-6 characterized in that said pin is retained on said receptacle post both by means of a pin retaining shoulder formed at the end of said post which engages a crimp formed in said pin when said pin is fully extended and by means of a saw cut formed in the end of said post.

11.  A contact probe assembly as in claim 9 or 10 characterized in that said saw cut is about 0.060 deep.

0068986

FIG. 1
PRIOR ART

FIG. 2

SECTION B-B

DETAIL A

FIG. 3

FIG.4

**European Patent Office**

**EUROPEAN SEARCH REPORT**

Application number

EP 82 40 1107

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | US-A-4 183 609 (L.J. LUNA) * Figures 3,4 * | 1 | G 01 R 1/067 G 01 R 1/073 |
| | --- | | |
| A | IBM TECHNICAL DISCLOSURE BULLETIN, vol. 18, no. 8, January 1976, pages 2487-2488, New York, USA R.W. BECK: "Switching probe" * Figures * | 1 | |
| | ----- | | |

|  |
|---|
| TECHNICAL FIELDS SEARCHED (Int. Cl. ³) |
| G 01 R 1/067 G 01 R 1/073 G 01 R 31/28 H 01 R 11/18 |

The present search report has been drawn up for all claims

| Place of search THE HAGUE | Date of completion of the search 18-08-1982 | Examiner KUSCHBERT D.E. |
|---|---|---|

EPO Form 1503. 03.82